(19) Europäisches Patentamt
European Patent Office
Office européen des brevets

(11) **EP 1 298 446 B1**

(12) **EUROPÄISCHE PATENTSCHRIFT**

(45) Veröffentlichungstag und Bekanntmachung des Hinweises auf die Patenterteilung:
**25.04.2007 Patentblatt 2007/17**

(51) Int Cl.:
*G01R 33/56* *(2006.01)*     *G01R 33/36* *(2006.01)*

(21) Anmeldenummer: **02020968.0**

(22) Anmeldetag: **19.09.2002**

(54) **Signalauswerteverfahren für Magnetresonanz-Empfangssignale und hiermit korrespondierende Empfangsanordnung**

Method of treatment of magnetic resonance reception signals and corresponding reception device

Méthode de traitement de signaux de réception de résonance magnétique et appareil de réception correspondant

(84) Benannte Vertragsstaaten:
**DE FI GB**

(30) Priorität: **01.10.2001 DE 10148445**

(43) Veröffentlichungstag der Anmeldung:
**02.04.2003 Patentblatt 2003/14**

(73) Patentinhaber: **SIEMENS AKTIENGESELLSCHAFT**
**80333 München (DE)**

(72) Erfinder: **Vester, Markus, Dr.**
**90471 Nürnberg (DE)**

(56) Entgegenhaltungen:
**EP-A- 0 256 520        DE-A- 4 232 827**
**US-A- 5 955 920**

**Beschreibung**

Die vorliegende Erfindung betrifft ein Signalauswerteverfahren für von mehreren Antennenelementen einer Arrayantenne für eine Magnetresonanzanlage aus einem Empfangsvolumen gelieferte Empfangssignale, wobei die Empfangssignale in einer Grundkombination miteinander kombiniert werden, so dass die Grundkombination ein zirkular polarisiertes Magnetresonanzsignal wiedergibt und die Grundkombination zur Bildrekonstruktion herangezogen wird.

Hiermit korrespondierend betrifft die vorliegende Erfindung auch eine Empfangsanordnung für eine Magnetresonanzanlage mit einer Arrayantenne mit mehreren Antennenelementen, mittels derer aus einem Empfangsvolumen Empfangssignale empfangbar sind, wobei die Empfangssignale einem Kombinationselement zuführbar sind, von dem die Empfangssignale in einer Grundkombination miteinander kombinierbar sind, die ein zirkular polarisiertes Magnetresonanzsignal wiedergibt, wobei die Grundkombination einem Bildrekonstruktionselement zuführbar ist, von dem die Grundkombination zur Bildrekonstruktion heranziehbar ist.

Derartige Signalauswerteverfahren und die korrespondierenden Empfangsanordnungen sind allgemein bekannt. Insbesondere die sogenannten birdcage-Resonatoren und die loop-butterfly-Elemente arbeiten nach diesem Prinzip.

Bei der Auswertung von Magnetresonanzsignalen ist allgemein ein sehr gutes Signal-Rausch-Verhältnis erforderlich. Um dieses gute Signal-Rausch-Verhältnis zu erzielen, werden im Stand der Technik oftmals mehrere Empfangssignale ausgewertet.

Aus der DE 42 32 827 A1 ist ein Signalauswerteverfahren für von mehreren Antennenelementen einer Arrayantenne für eine Magnetresonanzanlage aus einem Empfangsvolumen gelieferte Empfangssignale bekannt, bei dem die Empfangssignale von je drei örtlich unmittelbar aufeinander folgenden Antennenelementen zu je einem zirkular polarisierten Kombinationssignal kombiniert werden. Die Empfangssignale der anderen Antennenelemente tragen zu der jeweils betroffenen Kombination nicht bei. Zur Bildrekonstruktion werden die Kombinationssignale herangezogen.

Die Aufgabe der vorliegenden Erfindung besteht darin, ein Signalauswerteverfahren und eine hiermit korrespondierende Empfangsanordnung zu schaffen, mittels denen bei möglichst geringem Aufwand ein optimales Signal-Rausch-Verhältnis erzielbar ist.

Die Aufgabe wird durch ein Signalauswerteverfahren mit den Merkmalen des Anspruchs 1 bzw. eine Empfangsanordnung mit den Merkmalen des Anspruchs 11 gelöst.

Aufgrund der Orthogonalität der Kombinationen ist das Rauschen in den einzelnen Kombinationen unkorreliert. Die einzelnen Kombinationen sind also ohne weiteres quadratisch addierbar. Die Orthogonalität zweier Kombinationen ist dabei dadurch definiert, dass sie innerhalb des Empfangsvolumens die Gleichung

$$\int \sigma E1 E2 \, dV = 0$$

erfüllen, wobei σ die Leitfähigkeit von menschlichem Gewebe ist und E1 und E2 die von je einer der Kombinationen induzierten elektrischen Felder wären, wenn die Antennenelemente in dieser Kombination senden würden.

Die Kombinationen weisen in der Regel voneinander verschiedene Empfangssensitivitäten auf. Das Signal-Rausch-Verhältnis kann daher optimiert werden, wenn die Kombinationen zur Bildrekonstruktion mit ihrer jeweiligen Empfangssensitivität gewichtet herangezogen werden.

Vorzugsweise werden die Empfangssignale derart miteinander kombiniert, dass die Grundkombination im Zentrum des Empfangsvolumens eine von Null verschiedene Empfangssensitivität aufweist. Denn dadurch ergibt sich insbesondere im Zentrum des Empfangsvolumens eine gute Bildrekonstruktion.

Vorzugsweise werden die Empfangssignale derart miteinander kombiniert, dass die Grundkombination im Empfangsvolumen eine im wesentlichen ortsunabhängige Empfangssensitivität aufweist. Denn dadurch ist sogar unabhängig von der Anzahl der zur Bildrekonstruktion herangezogenen Zusatzkombinationen stets eine Bildrekonstruktion über das gesamte Empfangsvolumen möglich.

Vorzugsweise werden die Empfangssignale derart miteinander kombiniert, dass die Zusatzkombinationen im Zentrum des Empfangsvolumens eine Empfangssensitivität von Null aufweisen. Denn dadurch sind mit ihnen insbesondere die Randbereiche des Empfangsvolumens gut rekonstruierbar. Dies gilt ganz besonders, wenn die Kombination der Empfangssignale derart erfolgt, dass die Zusatzkombinationen im Empfangsvolumen eine bezüglich einer Symmetrieachse radial ansteigende Empfangssensitivität aufweisen. Die Empfangssensitivität einer der Zusatzkombinationen sollte dabei im wesentlichen linear mit dem Abstand des betrachteten Ortes von der Symmetrieachse ansteigen.

Die Empfangssignale können beispielsweise bezüglich einer Grundmagnetfeldrichtung azimutal erfasst werden. In diesem Fall müssen mindestens vier Empfangssignale erfasst werden.

Es ist aber auch möglich, die Empfangssignale bezüglich einer Grundmagnetfeldrichtung oder einer Hochfrequenzfeldrichtung longitudinal zu erfassen. In diesen Fällen ist es ausreichend, wenn mindestens zwei Empfangssignale erfasst werden.

Die Antennenelemente sollten für alle zur Bildrekonstruktion herangezogenen Kombinationen bei der Larmorfrequenz resonant sein. Hierzu ist es erforderlich, dass die Antennenelemente paarweise induktiv-kapazitiv voneinander entkoppelt sind. Die induktiv-kapazitive Entkopplung kann beispielsweise dadurch erreicht wer-

3      **EP 1 298 446 B1**      4

den, dass die Arrayantenne zu diesem Zweck ein Kondensatornetzwerk aufweist.

Wenn das Kombinationselement als Butlermatrix ausgebildet ist, ist es auf besonders einfache Weise realisierbar.

Wenn der Empfangsanordnung ein Sender zugeordnet ist, der über ein Verteilelement mit den Antennenelementen verbunden ist, und ein von dem Sender emittiertes Sendesignal von dem Verteilelement derart auf die Antennenelemente aufteilbar ist, das in das Empfangsvolumen ein Magnetresonanzanregungssignal eingespeist wird, ist mittels der Arrayantenne auch ein im Empfangsvolumen angeordnetes Objekt zu Magnetresonanzen anregbar.

Wenn das Verteilelement Bestandteil der Butlermatrix ist, ist der Aufbau des Verteilelements besonders einfach.

Wenn das Magnetresonanzanregungssignal im Empfangsvolumen eine im wesentlichen ortsunabhängige Anregungsintensität aufweist, wird im wesentlichen das gesamte Empfangsvolumen dem Magnetresonanzanregungssignal ausgesetzt.

Weitere Vorteile und Einzelheiten ergeben sich aus der nachfolgenden Beschreibung eines Ausführungsbeispiels in Verbindung mit den Zeichnungen. Dabei zeigen in Prinzipdarstellung

FIG 1      eine Empfangsanordnung für eine Magnetresonanzanlage,

FIG 2      ein Kombinationselement,

FIG 3      Wichtungsfunktionen für Kombinationen,

FIG 4      ein Bildrekonstruktionselement,

FIG 5      eine weitere Empfangsanordnung für eine Magnetresonanzanlage,

FIG 6      weitere Wichtungsfunktionen und

FIG 7      eine weitere Empfangsanordnung.

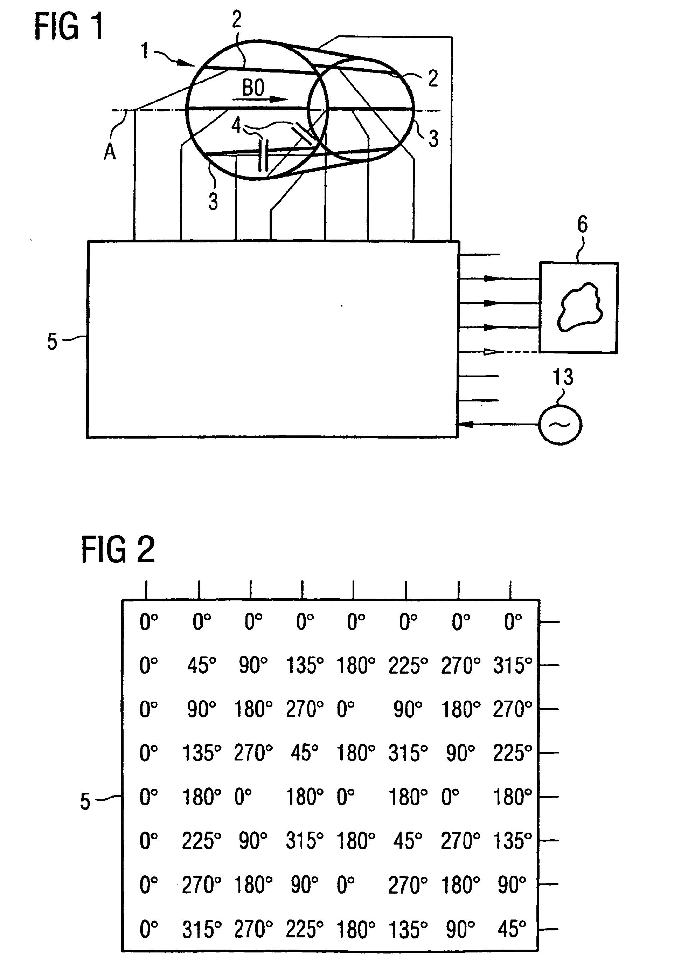

Gemäß FIG 1 weist eine Empfangsanordnung für eine Magnetresonanzanlage eine Arrayantenne 1 mit mehreren Antennenelementen 2 auf. Die Arrayantenne 1 gemäß FIG 1 ist als sogenannter birdcage-Resonator ausgebildet. Die Antennenelemente 2 werden somit durch die parallel zueinander verlaufenden Käfigstäbe des birdcage-Resonators gebildet. Sie sind ersichtlich bezüglich einer Grundmagnetfeldrichtung B0 azimutal angeordnet.

Gemäß FIG 1 weist die Arrayantenne 1 z. B. acht Antennenelemente 2 auf, die um eine Symmetrieachse A herum angeordnet sind. Prinzipiell könnte sie aber auch mehr oder weniger Antennenelemente 2 aufweisen. Aufgrund der Anzahl der Antennenelemente 2 und deren Anordnung werden also gemäß FIG 1 mindestens vier Empfangssignale bezüglich einer Grundmagnetfeldrichtung B0, die parallel zur Symmetrieachse A ist, azimutal erfasst.

Die Antennenelemente 2 sind gemäß FIG 1 durch Abschlussringe 3 miteinander verbunden. Der so gebildete Zylinder definiert ein Empfangsvolumen, aus dem die Antennenelemente 2 ihre Empfangssignale empfangen.

In den Antennenelementen 2 und/oder den Abschlussringen 3 sind in der Regel Kondensatoren angeordnet, die der Resonanzabstimmung der Antennenelemente 2 dienen. Diese Kondensatoren sind in FIG 1 der Übersichtlichkeit halber nicht mit eingezeichnet. Eingezeichnet sind aber zwei Kondensatoren 4 eines Kondensatornetzwerks. Mittels dieser beiden Kondensatoren 4 und der übrigen Kondensatoren des Kondensatornetzwerks wird erreicht, dass auch Antennenelemente 2, die nicht unmittelbar benachbart sind, induktiv-kapazitiv voneinander entkoppelt sind. Somit können alle Antennenelemente 2 paarweise induktiv-kapazitiv voneinander entkoppelt werden, unabhängig davon, ob sie nun unmittelbar benachbart sind oder nicht.

Die von den Antennenelementen 2 empfangenen Empfangssignale werden einem Kombinationselement 5 zugeführt. Das Kombinationselement 5 ist dabei als sogenannte Butlermatrix ausgebildet. Es weist somit eine Anzahl von Verzögerungs- und Additionselementen auf. Am Ausgang jeder Zeile der Butlermatrix 5 steht hierdurch eine Summe aller Empfangssignale an, wobei jedes Empfangssignal einer Spalte der Butlermatrix 5 zugeführt wird und dort einer spalten- und zeilenspezifischen Verzögerung unterzogen wird.

Die Verzögerungen der einzelnen Matrixelemente - bezogen auf die Larmorfrequenz - sind in FIG 2 dargestellt. Ersichtlich entsprechen die Verzögerungen einer analogen Fourierentwicklung der Empfangssignale.

Das Kombinationselement 5 bildet somit eine Anzahl von Kombinationen der Empfangssignale. Durch die in FIG 2 angegebenen Phasenverzögerungen ist dabei gewährleistet, dass alle Kombinationen orthogonal zueinander sind. Die der obersten Zeile der Butlermatrix 5 zugeordnete Kombination ergibt kein auswertbares Signal. Die an den Zeilen 2 bis 4 anstehenden Kombinationen sind (rein) gleichsinnig zirkular polarisiert. Die an der fünften Zeile anstehende Kombination ist linear polarisiert. Sie enthält somit (noch) eine Magnetresonanzsignalkomponente, die gleichsinnig mit den an den Zeilen 2 bis 4 anstehenden Kombinationen zirkular polarisiert ist. Die an den letzten drei Zeilen anstehenden Kombinationen sind untereinander wieder gleichsinnig zirkular polarisiert, aber zu den Kombinationen der Zeilen 2 bis 4 gegensinnig zirkular polarisiert.

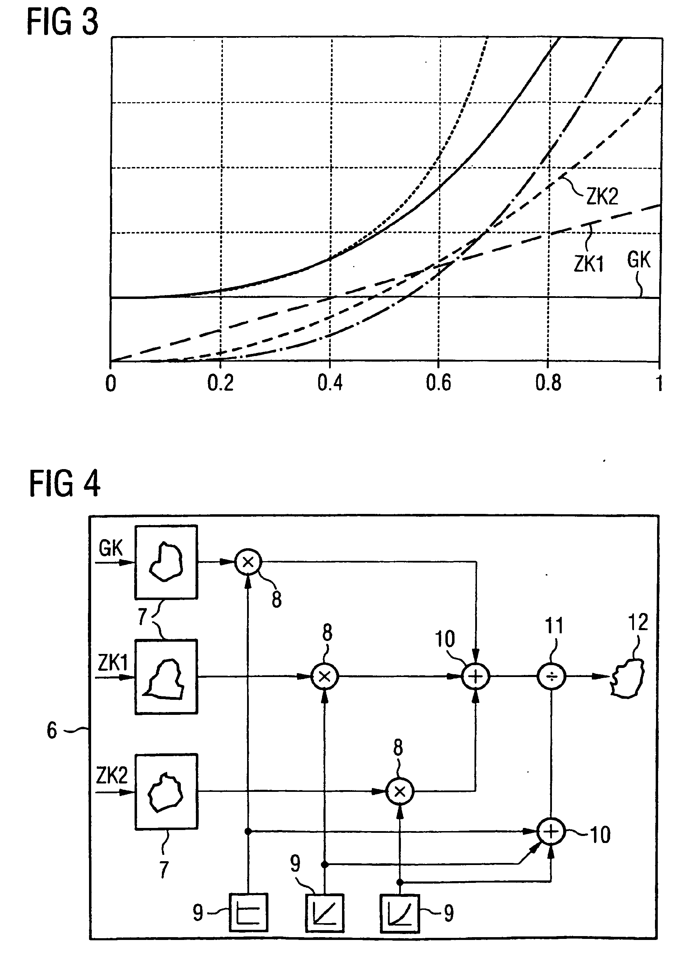

Die an der zweiten Zeile der Butlermatrix 5 anstehende Kombination, nachstehend Grundkombination GK genannt, weist eine im wesentlichen ortsunabhängige (homogene) Empfangssensitivität auf. Insbesondere im Zentrum des Empfangsvolumens weist sie somit ebenfalls eine von Null verschiedene Empfangssensitivität auf. Die Empfangssensitivität der Grundkombination GK ist in FIG 3 eingezeichnet.

Die an Zeile 3 anstehende Kombination, nachfolgende erste Zusatzkombination ZK1 genannt, weist

3

eine Empfangssensivität auf, die im Empfangsvolumen bezüglich der Symmetrieachse A von radial innen nach radial außen im wesentlichen linear ansteigt. Im Zentrum des Empfangsvolumens beträgt die Empfangssensivität der ersten Zusatzkombination ZK1 Null. Auch die Empfangssensitivität der ersten Zusatzkombination ZK1 ist in FIG 3 eingezeichnet.

Die an Zeile 4 abgreifbare Kombination, nachfolgend zweite Zusatzkombination ZK2 genannt, weist eine Empfangssensivität auf, die im Empfangsvolumen von radial innen nach radial außen im wesentlichen quadratisch ansteigt. Sie weist somit im Zentrum des Empfangsvolumens ebenfalls eine Empfangssensivität von Null auf. Auch die Empfangssensivität der zweiten Zusatzkombination ZK2 ist in FIG 3 eingezeichnet.

Ferner kann noch die in Zeile 5 anstehende Kombination herangezogen werden, deren Empfangssensivität von radial innen nach radial außen mit der dritten Potenz ansteigt. Diese Kombination ist im vorliegenden Fall, bei der nur acht Antennenelemente 2 verwendet werden, jedoch kein rein zirkular polarisiertes Magnetresonanzsignal mehr.

Die Grundkombination GK und die beiden Zusatzkombinationen ZK1, ZK2 werden einem Bildrekonstruktionselement 6 zugeführt, das in FIG 4 detailliert dargestellt ist. Von diesem werden die Grundkombination GK und die beiden Zusatzkombinationen ZK1, ZK2 zur Bildrekonstruktion herangezogen.

Im Bildrekonstruktionselement 6 werden die einzelnen Kombinationen GK, ZK1, ZK2 gemäß FIG 4 Signalauswertestufen 7 zugeführt. Die Signalauswertestufen 7 rekonstruieren in an sich bekannter Weise jeweils ein Bild eines im Empfangsvolumen angeordneten Objekts. Die Ausgangssignale der Signalauswertestufen 7 werden Multiplikationsstufen 8 zugeführt, denen weiterhin die Ausgangssignale von Wichtungsfunktionsgeneratoren 9 zugeführt werden. Die Wichtungsfunktionsgeneratoren 9 liefern ein Ausgangssignal, das proportional zu den in FIG 3 dargestellten Empfangssensivitäten ist. In den nachfolgenden Additionsstufen 10 und der Divisionsstufe 11 wird dann der normierte Mittelwert der entsprechend gewichteten Einzelbildrekonstruktionen ermittelt und als Gesamtbild 12 ausgegeben. Die Kombinationen GK, ZK1, ZK2 werden also im Ergebnis zur Bildrekonstruktion mit ihrer jeweiligen Empfangssensivität gewichtet herangezogen.

Wie bereits erwähnt, sind die unteren drei Zeilen der Butlermatrix 5 zwar zirkular polarisierte Signale, sie weisen aber für den Empfang den verkehrten Drehsinn auf. Dennoch ist auch eine Nutzung der unteren Zeilen der Butlermatrix 5 möglich. Denn beispielsweise kann der Empfangsanordnung ein Sender 13 zugeordnet sein, dessen Signal in eine Zeile der Butlermatrix 5 eingespeist wird. Die Butlermatrix 5 wirkt in diesem Fall als Verteilelement für ein von dem Sender 13 emittiertes Sendesignal. Durch Einspeisung in eine der unteren drei Zeilen der Butlermatrix 5 wird somit erreicht, dass das Sendesignal von der Butlermatrix 5 derart auf die Antennenelemente 2 aufgeteilt wird, dass in das Empfangsvolumen ein Magnetresonanzanregungssignal eingespeist wird. Bei Einspeisung in die unterste Zeile wird dabei im Empfangsvolumen ein Magnetresonanzanregungssignal mit einer im wesentlichen ortsunabhängigen Anregungsintensität generiert.

Die vorstehend in Verbindung mit azimutal bezüglich der Grundmagnetfeldrichtung B0 angeordneten Antennenelementen 2 beschriebene Vorgehensweise ist auch anwendbar, wenn die Antennenelemente 2 bezüglich der Grundmagnetfeldrichtung B0 oder einer Hochfrequenzfeldrichtung B1 longitudinal angeordnet sind.

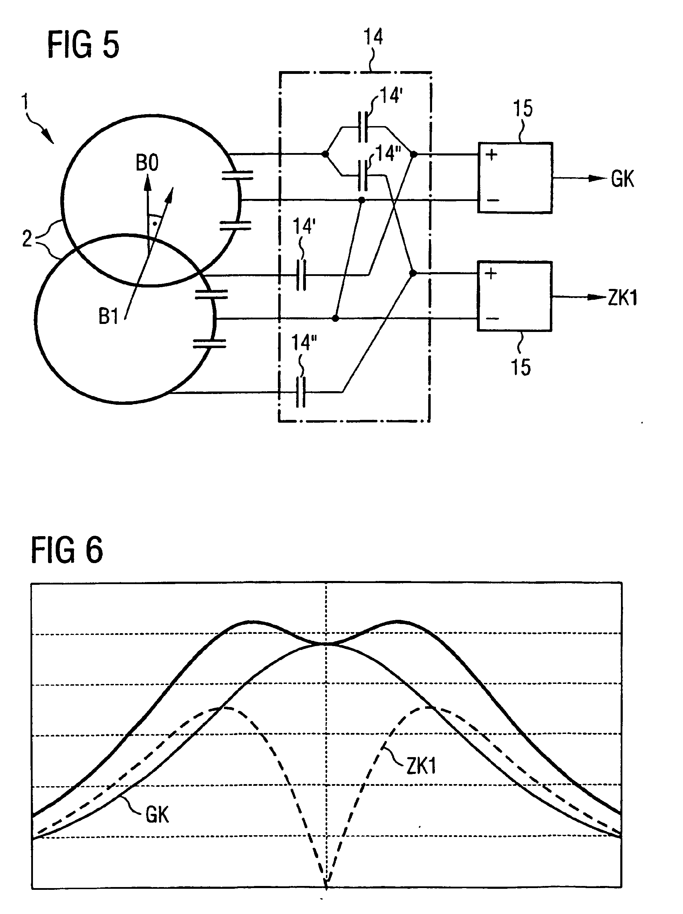

Eine Empfangsanordnung, bei der die Empfangssignale bezüglich der Hochfrequenzfeldrichtung B1 longitudinal erfasst werden, ist in FIG 5 dargestellt. Im Unterschied zur Ausführungsform gemäß den FIG 1 bis 4 werden in diesem Fall lediglich mindestens zwei Antennenelemente 2 benötigt, deren Empfangssignale erfasst werden.

Durch das in FIG 5 dargestellte Auskoppelnetzwerk 14 werden dabei ebenfalls orthogonale Kombinationen zur Verfügung gestellt, die beide gleichsinnig zirkular polarisierte Magnetresonanzsignalkomponenten enthalten. Die Kombinationen werden Vorverstärkern 15 zugeführt. Die dem oberen Vorverstärker 15 zugeführte Kombination, der sogenannte Helmholtz-Mode, entspricht der Grundkombination GK. Ihre Empfangssensivität ist in FIG 6 dargestellt. Die dem unteren Vorverstärker 15 zugeführte Kombination, der sogenannte "counterrotating-current-Mode" (siehe auch EP 0 256 520 B1), entspricht der ersten und einzigen Zusatzkombination ZK1. Die Empfangssensivität dieser Kombination ZK1 ist ebenfalls in FIG 6 dargestellt. Ferner mit dargestellt ist die Gesamtsensivität.

Der Helmholtz- und der counterrotating-current-Mode werden den Vorverstärkern 15 über das Auskoppelnetzwerk 14 und dessen Kondensatoren 14', 14" zugeführt, das somit auch als Impedanzwandler fungiert. Die Kondensatoren 14' weisen untereinander gleiche Kapazitätswerte auf, ebenso die Kondensatoren 14". Die Kapazitätswerte der Kondensatoren 14' sind aber größer als die der Kondensatoren 14". Dadurch kann das Transformationsverhalten für die beiden Modes voneinander verschieden sein. Das Auskoppelnetzwerk 14 wirkt also auch als modespezifisch ausgelegte Anpassschaltung 14.

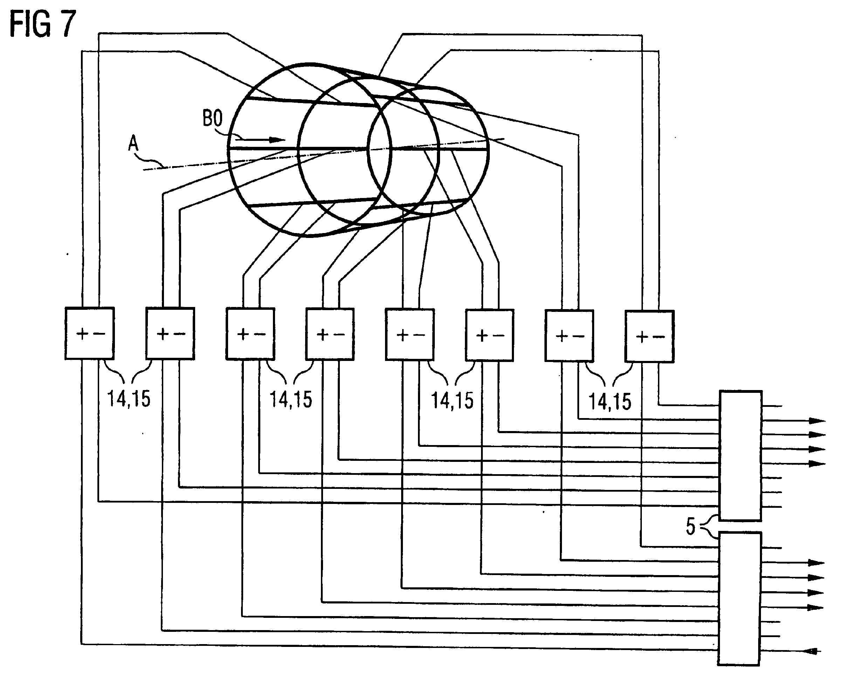

FIG 7 zeigt nun schematisch eine weitere Ausführungsform. In diesem Fall wird ein longitudinal zweigeteilter birdcage-Resonator mit je acht Käfigstäben verwendet. Durch die vorgeschalteten Auskoppelnetzwerke 14 mit nachgeordneten Vorverstärkern 15 werden für jedes longitudinal hintereinander angeordnete Käfigstabpaar ein Helmholtz- und ein counterrotating-current-Mode gebildet. Durch die nachgeordneten Butlermatrizen 5 werden dann die entsprechenden Azimutalmoden gebildet. Bezüglich der Bildung des Helmholtz- und des counterrotating-current-Mode sind bei der Ausführungsform gemäß FIG 7 die Antennenelemente 2 longitudinal bezüglich der Grundmagnetfeldrichtung B0 angeordnet.

Mit der vorliegenden Erfindung ist mit einer geringst möglichen Anzahl von Signalauswertestufen 7 eine optimale Bildrekonstruktion möglich.

Insbesondere ist es möglich, die Auskoppelnetzwerke 14 nebst nachgeordneten Additionsstufen 15 und die Butlermatrixen 5 stets vorzusehen und die den Butlermatrixen 5 nachgeordneten Signalauswertestufen 7 nach Bedarf einzusetzen. Somit kann, je nach Erfordernis des Einzelfalls, z. B. nur die Grundkombination GK oder nur die Grundkombination GK und die erste Zusatzkombination ZK1 oder die Grundkombination GK und beide Zusatzkombinationen ZK1, ZK2 ausgewertet werden. Gegebenenfalls kann auch die nur ein linear polarisiertes Magnetresonanzsignal ergebende dritte Zusatzkombination ZK3 mit zur Bildrekonstruktion herangezogen werden.

**Patentansprüche**

1. Signalauswerteverfahren für von mehreren Antennenelementen (2) einer Arrayantenne (1) für eine Magnetresonanzanlage aus einem Empfangsvolumen gelieferte Empfangssignale,

   - wobei die Empfangssignale in einer Grundkombination (GK) und in einer Anzahl von Zusatzkombinationen (ZK1, ZK2) miteinander kombiniert werden,
   - wobei jede Kombination (GK, ZK1, ZK2) Beiträge aller Empfangssignale enthält,
   - wobei die Kombinationen (GK, ZK1, ZK2) die Bedingung

$$\int \sigma E1 E2 dV = 0$$

   erfüllen, wobei σ die Leitfähigkeit von menschlichem Gewebe ist und E1 und E2 die von je einer der Kombinationen induzierten elektrischen Felder wären, wenn die Antennenelemente (2) in dieser Kombination senden würden,
   - wobei die Kombination (GK, ZK1, ZK2) gleichsinnig zirkular polarisierte Magnetresonanzsignalkomponenten enthalten und
   - wobei zur Bildrekonstruktion mindestens zwei Kombinationen (GK, ZK1, ZK2) herangezogen werden.

2. Signalauswerteverfahren nach Anspruch 1, **dadurch gekennzeichnet ,** **dass** die Kombinationen (GK, ZK1, ZK2) voneinander verschiedene Empfangssensitivitäten aufweisen und dass die Kombinationen (GK, ZK1, ZK2) zur Bildrekonstruktion mit ihrer jeweiligen Empfangssensitivität gewichtet herangezogen werden.

3. Signalauswerteverfahren nach Anspruch 1 oder 2, **dadurch gekennzeichnet ,** **dass** Empfangssignale derart miteinander kombiniert werden, dass die die Grundkombination (GK) im Zentrum des Empfangsvolumens eine von Null verschiedene Empfangssensitivität aufweist.

4. Signalauswerteverfahren nach Anspruch 3, **dadurch gekennzeichnet ,** **dass** Empfangssignale derart miteinander kombiniert werden, dass die Grundkombination (GK) im Empfangsvolumen eine im wesentlichen ortsunabhängige Empfangssensitivität aufweist.

5. Signalauswerteverfahren nach einem der Ansprüche 1 bis 4, **dadurch gekennzeichnet ,** **dass** Empfangssignale derart miteinander kombiniert werden, dass die die Zusatzkombinationen (ZK1, ZK2) im Zentrum des Empfangsvolumens eine Empfangssensitivität von Null aufweisen.

6. Signalauswerteverfahren nach Anspruch 5, **dadurch gekennzeichnet ,** **dass** Empfangssignale derart miteinander kombiniert werden, dass die die Zusatzkombinationen (ZK1, ZK2) im Empfangsvolumen eine bezüglich einer Symmetrieachse (A) radial ansteigende Empfangssensitivität aufweisen.

7. Signalauswerteverfahren nach Anspruch 6, **dadurch gekennzeichnet ,** **dass** Empfangssignale derart miteinander kombiniert werden, dass die die Empfangssensitivität einer (ZK1) der Zusatzkombinationen (ZK1, ZK2) im Empfangsvolumen im wesentlichen linear ansteigt.

8. Signalauswerteverfahren nach einem der Ansprüche 1 bis 7, **dadurch gekennzeichnet ,** **dass** die Empfangssignale bezüglich einer Grundmagnetfeldrichtung (B0) azimutal erfasst werden und dass mindestens vier Empfangssignale erfasst werden.

9. Signalauswerteverfahren nach einem der Ansprüche 1 bis 7, **dadurch gekennzeichnet ,** **dass** die Empfangssignale bezüglich einer Grundmagnetfeldrichtung (B0) oder einer Hochfrequenzfeldrichtung (B1) longitudinal erfasst werden und dass mindestens zwei Empfangssignale erfasst werden.

10. Signalauswerteverfahren nach Anspruch 9,

**dadurch gekennzeichnet ,**
**dass** die Kombinationen (GK, ZK1) mittels einer Anpassschaltung (14) voneinander verschieden transformiert werden.

11. Empfangsanordnung für eine Magnetresonanzanlage mit einer Arrayantenne (1) mit mehreren Antennenelementen (2), mittels derer aus einem Empfangsvolumen Empfangssignale empfangen werden

 - wobei die Empfangssignale einem Kombinationselement (5) zugeführt werden,
 - wobei die Empfangssignale von dem Kombinationselement (5) in einer Grundkombination (GK) und in einer Anzahl von Zusatzkombinationen (ZK1, ZK2) miteinander kombiniert werden,
 - wobei Mittel vorgesehen sind zur Durchführung des Verfahrens nach Anspruch 1,
 - wobei die Kombinationen (GK, ZK1, ZK2) einem Bildrekonstruktionelement (6) zugeführt werden, von dem die Grundkombination (GK) und mindestens eine der Zusatzkombinationen zur Bildrekonstruktion (ZK1, ZK2) herangezogen werden.

12. Empfangsanordnung nach Anspruch 11,
**dadurch gekennzeichnet ,**
**dass** die Kombinationen (GK, ZK1, ZK2) voneinander verschiedene Empfangssensitivitäten aufweisen und dass die Kombinationen (GK, ZK1, ZK2) zur Bildrekonstruktion mit ihrer jeweiligen Empfangssensitivität gewichtet heranziehbar sind.

13. Empfangsanordnung nach Anspruch 11 oder 12,
**dadurch gekennzeichnet ,**
**dass** Empfangssignale derart miteinander kombiniert werden, dass die die Grundkombination (GK) im Zentrum des Empfangsvolumens eine von Null verschiedene Empfangssensitivität aufweist.

14. Empfangsanordnung nach Anspruch 13,
**dadurch gekennzeichnet ,**
**dass** Empfangssignale derart miteinander kombiniert werden, dass die die Grundkombination (GK) im Empfangsvolumen eine im wesentlichen ortsunabhängige Empfangssensitivität aufweist.

15. Empfangsanordnung nach einem der Ansprüche 11 bis 14,
**dadurch gekennzeichnet ,**
**dass** Empfangssignale derart miteinander kombiniert werden, dass die die Zusatzkombinationen (ZK1, ZK2) im Zentrum des Empfangsvolumens eine Empfangssensitivität von Null aufweisen.

16. Empfangsanordnung nach Anspruch 15,

**dadurch gekennzeichnet ,**
**dass** Empfangssignale derart miteinander kombiniert werden, dass die die Zusatzkombinationen (ZK1, ZK2) im Empfangsvolumen eine bezüglich einer Symmetrieachse (A) radial ansteigende Empfangssensitivität aufweisen.

17. Empfangsanordnung nach Anspruch 16,
**dadurch gekennzeichnet ,**
**dass** Empfangssignale derart miteinander kombiniert werden, dass die die Empfangssensitivität einer (ZK1) der Zusatzkombinationen (ZK1, ZK2) im Empfangsvolumen im wesentlichen linear ansteigt.

18. Empfangsanordnung nach einem der Ansprüche 11 bis 17,
**dadurch gekennzeichnet ,**
**dass** die Arrayantenne (1) mindestens vier bezüglich einer Grundmagnetfeldrichtung (B0) azimutal angeordnete Antennenelemente (2) aufweist.

19. Empfangsanordnung nach einem der Ansprüche 11 bis 17,
**dadurch gekennzeichnet ,**
**dass** die Arrayantenne (1) mindestens zwei bezüglich einer Grundmagnetfeldrichtung (B0) oder einer Hochfrequenzfeldrichtung (B1) longitudinal angeordnete Antennenelemente (2) aufweist.

20. Signalauswerteverfahren nach Anspruch 19,
**dadurch gekennzeichnet ,**
**dass** die Kombination (GK, ZK1) einer Anpassschaltung (14) zuführbar sind, mittels derer sie voneinander verschieden transformiert werden.

21. Empfangsanordnung nach einem der Ansprüche 11 bis 20,
**dadurch gekennzeichnet ,**
**dass** die Antennenelemente (2) paarweise induktivkapazitiv voneinander entkoppelt sind.

22. Empfangsanordnung nach Anspruch 21,
**dadurch gekennzeichnet ,**
**dass** die Arrayantenne (1) zur paarweise induktivkapazitiven Entkopplung der Antennenelemente (2) voneinander ein Kondensatornetzwerk (4) aufweist.

23. Empfangsanordnung nach einem der Ansprüche 11 bis 22,
**dadurch gekennzeichnet ,**
**dass** das Kombinationselement (5) als Butlermatrix (5) ausgebildet ist.

24. Empfangsanordnung nach einem der Ansprüche 11 bis 23,
**dadurch gekennzeichnet ,**
**dass** ihr ein Sender (13) zugeordnet ist, der über ein Verteilelement mit den Antennenelementen (2) verbunden ist, und dass ein von dem Sender (13) emittiertes Sendesignal von dem Verteilelement derart auf die Antennenelemente (2) aufgeteilt wird, dass in das Empfangsvolumen ein Magnetresonanzanregungssignal eingespeist wird.

25. Empfangsanordnung nach Anspruch 23 und 24, **dadurch gekennzeichnet ,**
**dass** das Verteilelement Bestandteil der Butlermatrix (5) ist.

26. Empfangsanordnung nach Anspruch 24 oder 25, **dadurch gekennzeichnet ,**
**dass** das Magnetresonanzanregungssignal im Empfangsvolumen eine im wesentlichen ortsunabhängige Anregungsintensität aufweist.

**Claims**

1. Signal evaluation method for reception signals supplied from a reception volume by a number of antenna elements (2) of an array antenna (1) for a magnetic resonance apparatus,

 - with the reception signals being combined with one another in a basic combination (GK) and in a number of auxiliary combinations (ZK1, ZK2),
 - with each combination (GK, ZK1, ZK2) containing contributions of all reception signals,
 - with the combinations (GK, ZK1, ZK2) satisfying the condition

$$c_{E1E2} \ dV = 0$$

wherein σ is the conductivity of human tissue and E1 and E2 are the electrical fields induced by each one of the combinations if the antenna elements (2) in this combination were transmitting.

 - with the combination (GK, ZK1, ZK2) containing isodirectionally circularly polarised magnetic resonance signal components and
 - with at least two combinations (GK, ZK1, ZK2) being utilised for image reconstruction.

2. Signal evaluation method according to claim 1 **characterised in that**
the combinations (GK, ZK1, ZK2) have reception sensitivities which differ from each other, and that the combinations (GK, ZK1, ZK2) are utilised for image reconstruction weighted with their respective reception sensitivities.

3. Signal evaluation method according to claim 1 or 2 **characterised in that**

reception signals are combined with one another such that the basic combination (GK) exhibits a reception sensitivity differing from zero in the centre of the reception volume.

4. Signal evaluation method according to claim 3 **characterised in that**
reception signals are combined with one another such that the basic combination (GK) exhibits an essentially location-independent reception sensitivity in the reception volume.

5. Signal evaluation method according to one of claims 1 to 4,
**characterised in that**
reception signals are combined with one another such that the auxiliary combinations (ZK1, ZK2) exhibit a reception sensitivity of zero in the centre of the reception volume.

6. Signal evaluation method according to claim 5 **characterised in that**
reception signals are combined with one another such that the auxiliary combinations (ZK1, ZK2) exhibit a radially increasing reception sensitivity in the reception volume with reference to a symmetry axis (A).

7. Signal evaluation method according to claim 6 **characterised in that**
reception signals are combined with one another such that the reception sensitivity of one (ZK1) of the auxiliary combinations (ZK1, ZK2) increases essentially linearly in the reception volume.

8. Signal evaluation method according to one of claims 1 to 7,
**characterised in that**
the reception signals are acquired azimuthally in respect of a basic magnetic field (B0) and that at least four reception signals are acquired.

9. Signal evaluation method according to one of claims 1 to 7
**characterised in that**
the reception signals are acquired longitudinally in respect of a basic magnetic field direction (B0) or a radiofrequency field direction (B1) and that at least two reception signals are acquired.

10. Signal evaluation method according to claim 9 **characterised in that**
the combinations (GK, ZK1) are transformed differently from each other by means of a matching circuit (14).

11. Reception arrangement for a magnetic resonance system comprising an array antenna (1) having a plurality of antenna elements (2) by means of which reception signals are received from a reception volume,

- with the reception signals being fed to a combination element (5)
- with the reception signals of the combination element (5) being combined with one another in a basic combination (GK) and in a number of auxiliary combinations (ZK1, ZK2)
- with means being provided for implementing the method according to claim 1 and
- with the combinations (GK, ZK1, ZK2) being fed to an image reconstruction element (6), from which the basic combination (GK) and at least one of the auxiliary combinations are utilised for image reconstruction (ZK1, ZK2).

12. Reception arrangement according to claim 11
**characterised in that**
the combinations (GK, ZK1, ZK2) comprise reception sensitivities which differ from one another and that the combinations (GK, ZK1, ZK2) can be utilised for image reconstruction weighted with their respective reception sensitivity.

13. Reception arrangement according to claim 11 or 12
**characterised in that**
reception signals are combined with one another such that the basic combination (GK) comprises a reception sensitivity differing from zero in the centre of the reception volume.

14. Reception arrangement according to claim 13
**characterised in that**
reception signals are combined with one another such that
the basic combination (GK) comprises a substantially location-independent reception sensitivity in the reception volume.

15. Reception arrangement according to one of claims 11 to 14
**characterised in that**
reception signals are combined with one another such that the auxiliary combinations (ZK1,ZK2) exhibit a reception sensitivity of zero in the centre of the reception volume.

16. Reception arrangement according to claim 15
**characterised in that**
reception signals are combined with one another such that the auxiliary combinations (ZK1, ZK2) each exhibit a radially increasing reception sensitivity in the reception volume with reference to a symmetry axis (A).

17. Reception arrangement according to claim 16

**characterised in that**
reception signals are combined with one another such that the reception sensitivities of one (ZK1) of the auxiliary combinations (ZK1, ZK2) increase essentially linearly in the reception volume.

18. Reception arrangement according to one of claims 11 to 17,
**characterised in that**
the array antenna (1) comprises at least four antenna elements (2) arranged azimuthally relative to a basic magnetic field direction (B0).

19. Reception arrangement according to one of claims 11 to 17,
**characterised in that**
the array antenna (1) comprises at least two antenna elements (2) arranged longitudinally relative to a basic magnetic field direction (B0) or a radiofrequency field direction (B1).

20. Signal evaluation method according to claim 19
**characterised in that**
the combination (GK, ZK1) of a matching circuit (14) can be supplied, by means of which they can be transformed differently from one another.

21. Reception arrangement according to one of claims 11 to 20,
**characterised in that**
the antenna elements (2) are inductively-capacitively decoupled from one another in pairs.

22. Reception arrangement according to claim 21
**characterised in that**
the array antenna (1) exhibits a capacitor network (4) for the inductive-capacitative decoupling of the antenna elements (2) from one another in pairs.

23. Reception arrangement according to one of claims 11 to 22,
**characterised in that**
the combination element (5) is designed as a Butler matrix (5).

24. Reception arrangement according to one of claims 11 to 23,
**characterised in that** a transmitter (13) connected to said antenna elements (2) via a distributor element is assigned thereto, and that a transmission signal emitted by the transmitter (13) is distributed among said antenna elements (2) by the distributor element such that a magnetic resonance excitation signal is fed into the reception volume.

25. Reception arrangement according to claim 23 and 24,

characterised in that
the distributor element is a component of the Butler matrix (5).

26. Reception arrangement according to claim 24 or 25
**characterised in that**
the magnetic resonance excitation signal exhibits an essentially location-independent excitation intensity in the reception volume.

**Revendications**

1. Procédé d'exploitation de signaux pour des signaux de réception fournis à partir d'un volume de réception par plusieurs éléments (2) d'une antenne (1) en réseau pour une installation de résonance magnétique,

   - dans lequel on combine entre eux les signaux de réception en une combinaison (GK) de base et en un certain nombre de combinaisons (ZK1, ZK2) supplémentaires ;
   - dans lequel chaque combinaison (GK, ZK1, ZK2) contient des contributions de tous les signaux de réception ;
   - dans lequel les combinaisons (GK, ZK1, ZK2) satisfont la condition

$$\int \sigma E1 E2 \, dV = 0$$

   σ étant la conductivité du tissu humain et E1 et E2 étant les champs électriques qui seraient induits par, respectivement, l'une des combinaisons si les éléments (2) d'antenne émettaient dans cette combinaison ;
   - dans lequel les combinaisons (GK, ZK1, ZK2) contiennent des composantes de signal de résonance magnétiques polarisées circulairement dans le même sens ; et
   - dans lequel on tire parti d'au moins deux combinaisons (GK, ZK1, ZK2) pour la reconstruction de l'image.

2. Procédé d'exploitation de signaux suivant la revendication 1,
   **caractérisé**
   **en ce que** les combinaisons (GK, ZK1, ZK2) ont des sensibilités de réception différentes les unes des autres et en ce que les combinaisons (GK, ZK1, ZK2) sont mises à profit pour la reconstruction de l'image de façon pondérée par leur sensibilité de réception respective.

3. Procédé d'exploitation de signaux suivant la revendication 1 ou 2,

caractérisé
**en ce que** l'on combine les signaux de réception entre eux de façon à ce que la combinaison (GK) de base ait au centre du volume de réception une sensibilité de réception différente de zéro.

4. Procédé d'exploitation de signaux suivant la revendication 3,
   **caractérisé**
   **en ce que** l'on combine entre eux des signaux de réception de façon à ce que la combinaison (GK) de base ait dans le volume de réception une sensibilité de réception qui est sensiblement indépendante de l'emplacement.

5. Procédé d'exploitation de signaux suivant l'une des revendications 1 à 4,
   **caractérisé**
   **en ce que** l'on combine entre eux des signaux de réception de façon à ce que les combinaisons (ZK1, ZK2) supplémentaires aient au centre du volume de réception une sensibilité de réception de zéro.

6. Procédé d'exploitation de signaux suivant la revendication 5,
   **caractérisé**
   **en ce que** l'on combine entre eux des signaux de réception de façon à ce que les combinaisons (ZK1, ZK2) supplémentaires aient dans le volume de réception une sensibilité de réception augmentant radialement par rapport à un axe (A) de symétrie.

7. Procédé d'exploitation de signaux suivant la revendication 6,
   **caractérisé**
   **en ce que** l'on combine entre eux des signaux de réception de façon à ce que la sensibilité de réception de l'une (ZK1) des combinaisons (ZK1, ZK2) supplémentaires augmente de façon sensiblement linéaire dans le volume de réception.

8. Procédé d'exploitation de signaux suivant l'une des revendications 1 à 7,
   **caractérisé**
   **en ce que** l'on détecte les signaux de réception de façon azimutale par rapport à une direction (B0) du champ magnétique de base et en ce que l'on détecte au moins quatre signaux de réception.

9. Procédé d'exploitation de signaux suivant l'une des revendications 1 à 7,
   **caractérisé**
   **en ce que** l'on détecte les signaux de réception longitudinalement par rapport à une direction (B0) de champ magnétique de base ou par rapport à une direction (B1) de champ en haute fréquence et on détecte au moins deux signaux de réception.

**10.** Procédé d'exploitation de signaux suivant la revendication 9,
**caractérisé**
**en ce que** l'on transforme les combinaisons (GK, ZK1) de façon différente l'une de l'autre au moyen d'un circuit (14) d'adaptation.

**11.** Dispositif de réception d'une installation de résonance magnétique comprenant une antenne (1) en réseau ayant plusieurs éléments (2) d'antenne au moyen desquels des signaux de réception sont reçus à partir d'un volume de réception,

- dans lequel les signaux de réception sont envoyés à un élément (5) de combinaison ;
- dans lequel les signaux de réception de l'élément (5) de combinaison sont combinés entre eux en une combinaison (GK) de base et en un certain nombre de combinaisons (ZK1) ZK2) supplémentaires ;
- dans lequel il est prévu des moyens pour effectuer le procédé suivant la revendication 1 ;
- dans lequel les combinaisons (GK, ZK1, ZK2) sont envoyées à un élément (6) de reconstruction de l'image par lequel la combinaison (GK) de base et au moins l'une des combinaisons supplémentaires sont mises à profit pour la reconstruction (ZK1, ZK2) de l'image.

**12.** Dispositif de réception suivant la revendication 11,
**caractérisé**
**en ce que** les combinaisons (GK, ZK1, ZK2) ont des sensibilités de réception différentes les unes des autres et en ce que les combinaisons (GK, ZK1, ZK2) sont mises à profit de façon pondérée par leur sensibilité respective de réception pour la reconstruction de l'image.

**13.** Dispositif de réception suivant la revendication 11 ou 12,
**caractérisé**
**en ce que** des signaux de réception sont combinés entre eux de façon à ce que la combinaison (GK) de base ait au centre du volume de réception une sensibilité de réception différente de zéro.

**14.** Dispositif de réception suivant la revendication 13,
**caractérisé**
**en ce que** des signaux de réception sont combinés entre eux de façon à ce que la combinaison (GK) de base ait dans le volume de réception une sensibilité de réception sensiblement indépendante de l'emplacement.

**15.** Dispositif de réception suivant l'une des revendications 11 à 14,
**caractérisé**
**en ce que** des signaux de réception sont combinés entre eux de façon à ce que les combinaisons (ZK1, ZK2) supplémentaires aient au centre du volume de réception une sensibilité de réception de zéro.

**16.** Dispositif de réception suivant la revendication 15,
**caractérisé**
**en ce que** des signaux de réception sont combinés entre eux de façon à ce que les combinaisons (ZK1, ZK2) supplémentaires aient dans le volume de réception une sensibilité de réception augmentant radialement par rapport à un axe (A) de symétrie.

**17.** Dispositif de réception suivant la revendication 16,
**caractérisé**
**en ce que** des signaux de réception sont combinés entre eux de façon à ce que la sensibilité de réception de l'une (ZK1) des combinaisons (ZK1, ZK2) supplémentaires augmente de façon sensiblement linéaire dans le volume de réception.

**18.** Dispositif de réception suivant l'une des revendications 11 à 17,
**caractérisé**
**en ce que** l'antenne (1) en réseau a au moins quatre éléments (2) d'antenne disposés azimutalement par rapport à une direction (B0) de champ magnétique de base.

**19.** Dispositif de réception suivant l'une des revendications 11 à 17,
**caractérisé**
**en ce que** l'antenne (1) en réseau a au moins deux éléments (2) d'antenne disposés longitudinalement par rapport à une direction (B0) de champ magnétique de base ou par rapport à une direction (B1) de champ en haute fréquence.

**20.** Dispositif de réception suivant la revendication 19,
**caractérisé**
**en ce que** les combinaisons (GK, ZK1) sont envoyées à un circuit (14) d'adaptation au moyen duquel elles sont transformées de manière différente les unes des autres.

**21.** Dispositif de réception suivant l'une des revendications 11 à 20,
**caractérisé**
**en ce que** les éléments (2) d'antenne sont découplés les uns des autres par paire de façon inductive-capacitive.

**22.** Dispositif de réception suivant la revendication 21,
**caractérisé**
**en ce que** l'antenne (1) à réseau a un réseau (4) de condensateurs pour le découplage par paire de façon inductive-capacitive des éléments (2) d'antenne les uns des autres.

**23.** Dispositif de réception suivant l'une des revendications 11 à 22,
**caractérisé**
**en ce que** l'élément (5) de combinaison est réalisé sous la forme d'une matrice Butler.

**24.** Dispositif de réception suivant l'une des revendications 11 à 23,
**caractérisé**
**en ce qu'**il lui est associé un émetteur (13) qui est relié par un élément répartiteur aux éléments (2) d'antenne et en ce qu'un signal d'émission émis par l'émetteur (13) est réparti par l'élément de répartition sur les éléments (2) d'antenne de façon à injecter un signal d'excitation de résonance magnétique dans le volume de réception.

**25.** Dispositif de réception suivant la revendication 23 et 24,
**caractérisé**
**en ce que** l'élément de répartition fait partie de la matrice (5) de Butler.

**26.** Dispositif de réception suivant la revendication 24 ou 25,
**caractérisé**
**en ce que** le signal d'excitation de résonance magnétique a dans le volume de réception une intensité d'excitation sensiblement indépendante de l'emplacement.

## FIG 1

B0

A

2
1
2
3
4
3

5

6

13

## FIG 2

| 0° | 0° | 0° | 0° | 0° | 0° | 0° | 0° |
|---|---|---|---|---|---|---|---|
| 0° | 45° | 90° | 135° | 180° | 225° | 270° | 315° |
| 0° | 90° | 180° | 270° | 0° | 90° | 180° | 270° |
| 0° | 135° | 270° | 45° | 180° | 315° | 90° | 225° |
| 0° | 180° | 0° | 180° | 0° | 180° | 0° | 180° |
| 0° | 225° | 90° | 315° | 180° | 45° | 270° | 135° |
| 0° | 270° | 180° | 90° | 0° | 270° | 180° | 90° |
| 0° | 315° | 270° | 225° | 180° | 135° | 90° | 45° |

5

FIG 3

FIG 4

## FIG 5

## FIG 6

FIG 7